# EUROPEAN PATENT SPECIFICATION

(11) **EP 0 665 640 B1**
(45) Date of publication and mention of the grant of the patent: **04.08.1999**
(21) Application number: 95300179.9
(22) Date of filing: 12.01.1995
(51) Int. Cl.: H03F 3/45

(54) **Transconductance floating resistor circuit**
Schwebender Widerstand in Transkonduktanzschaltung
Circuit de transconductance pour une résistance flottante

(30) Priority: 29.01.1994 GB 9401718
(43) Date of publication of application: 02.08.1995
(73) Proprietor: Mitel Semiconductor Limited, Swindon, Wiltshire SN2 2QW (GB)
(72) Inventor: Laws, Peter Graham, Swindon, Wilts, SN5 5AG (GB)
(74) Representative: Blatchford, William Michael

(56) References cited:
- EP-A- 0 260 753
- EP-A- 0 421 530
- GB-A- 2 175 763
- IEEE JOURNAL OF SOLID-STATE CIRCUITS, vol. 28,no. 12, December 1993 NEW YORK,US, pages 1246-1252, XP 000435897 KOYAMA ET AL. 'A 2.5-V ACTIVE LOW-PASS FILTER USING ALL N-P-N GILBERT CELLS WITH A 1-V LINEAR INPUT RANGE'

## Description

The invention concerns a transconductance floating resistor circuit, and in particular, but not exclusively, a transconductance floating resistor circuit for use in a gyrator filter.

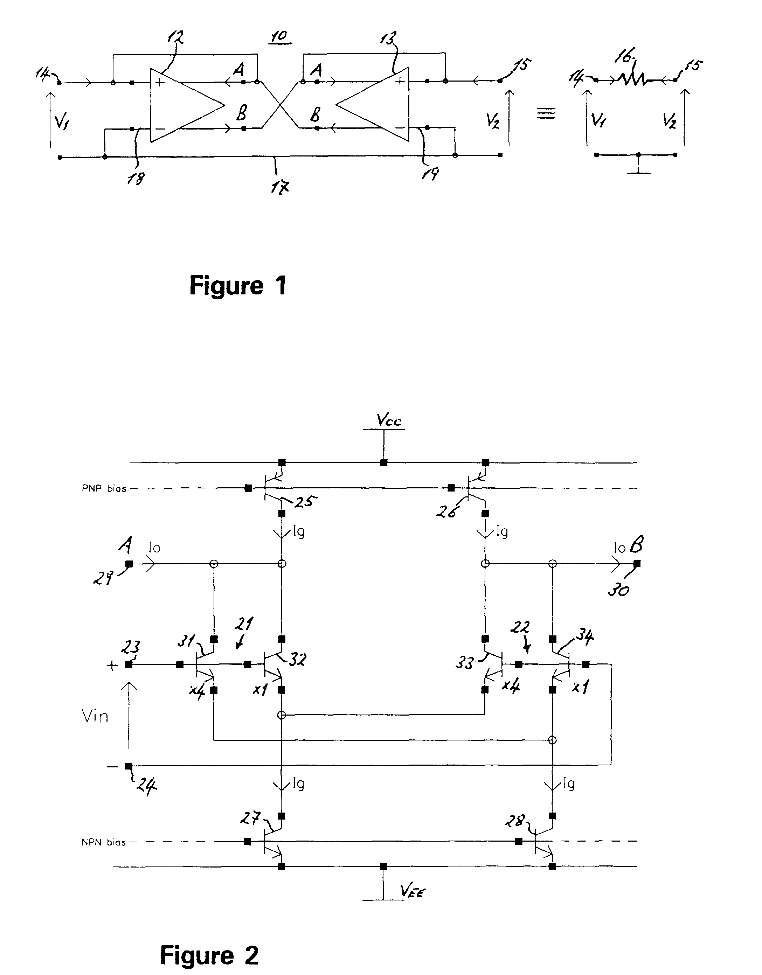

LC filters (as e.g. known from IEEE JSSC 28, 12, pp. 1246-1252) are commonly realised as gyrator circuits, in which the inductive elements of the filters are gyrated from capacitors using transconductance amplifiers. Such filter arrangements require to be terminated at both input and output by the characteristic impedance of the filter circuit, and in the case of gyrator circuits this is realised by a floating resistor formed from matched transconductance stages. Figure 1 shows a typical known transconductance floating resistor circuit 10, in which two transconductance amplifiers 12 and 13 are arranged in such a way as to simulate between the input and output terminals 14 and 15 a resistor having a value related to the transconductance of the amplifiers used. This resistor is shown on the right hand side of the drawing as the resistor 16. The transconductance amplifiers 12, 13 are commonly realised as the circuit shown in Figure 2, in which a differential amplifier comprising composite halves 21, 22 is fed from respective PNP and NPN current sources 25, 26 and 27, 28, the differential outputs 29, 30 of the differential amplifier being taken from the commoned collectors of the respective halves 21, 22 of the differential amplifier and the differential inputs 23, 24 being taken to the parallel-connected bases of the respective halves 21, 22.

Returning to Figure 1, it should be noted that, although there is shown a common reference potential 17 to which both input and output are referred, the resistor formed by this arrangement is not itself directly referred to this potential, but is what is known as "floating". However, the common reference potential 17 is still used by the transconductance amplifiers 12, 13 in order to ensure correct biasing for the negative inputs 18, 19.

In the known filter arrangement, in which the circuit of Figure 1 is used for impedance matching before the main gyrator circuit, in order for the floating resistor of Figure 1 not to load an input signal Vin from a previous stage too much, a buffer is added upstream of the resistor having a high input impedance. However, in the interests of maintaining the required impedance of the floating input resistance, the buffer must also exhibit a low output impedance. This in turn demands that the buffer be operated at high current levels, increasing the power consumption of the gyrator circuit as a whole. In addition to this, care has to be taken to minimise voltage offsets in the buffer stage, since even small offsets can reduce the dynamic range of the following gyrator stage.

It is the aim of the invention to mitigate the above drawbacks of the known floating-resistor gyrator input arrangements.

In accordance with a first aspect of the invention, there is provided a transconductance floating resistor circuit comprising a differential transconductance amplifier having first and second inputs and corresponding first and second outputs, the first and second outputs being connected to the first and second inputs, respectively, and the input and output of the floating resistor circuit being taken from the first and second inputs, respectively, of the transconductance amplifier.

This arrangement has the advantage of providing a single-stage floating resistor, thereby saving on hardware, and in addition the circuit is unconditionally stable and has well-defined bias conditions since the active transistors in the transconductor amplifier (i.e. transistors 31-34 in Figure 2) have their respective bases and collectors shorted together. These transistors are now effectively connected as diodes and produce no signal gain. For small input signals, the resulting circuit is the equivalent of a floating resistor having a resistance value which is a function of the total effective internal emitter resistance (rₑ) of the composite differential halves 21, 22.

The floating resistor circuit may be modified by arranging for the first output of the transconductance amplifier to be connected to a reference potential instead of to the first input of the transconductance amplifier, the reference potential forming a common reference level for the input and output of the floating resistor circuit.

The result of this modification is that, by virtue of the disconnection of the current feedback to the first input terminal of the amplifier, the amplifier now has a high input impedance, but at the same time the output impedance, i.e. the floating resistance as seen by the subsequent filter stage, is unaffected. The resulting arrangement is equivalent to a floating resistor stage preceded by a buffer stage. The stability of the circuit is maintained since it now becomes equivalent to an emitter follower followed by a diode. The circuit now has unidirectional properties that make it highly suitable for the input stage in gyrator filters.

A further advantage to be gained by modifying the floating resistor according to the invention as mentioned above, is that when the modified resistor circuit is used as the input stage of a gyrator circuit, the differential inputs (terminals 23, 24 in Figure 2) of the resistor circuit see only half the input signal voltage for signal frequencies which are in-band. When the known resistor circuit of Figure 1 is used in this position, the resistor circuit sees the full input signal voltage across its differential input terminals. Consequently, the buffer/resistor arrangement of the invention exhibits twice the signal-handling capability of the known arrangement. There is no change in out-of-band signal handling, however; the full input signal appears in this case across the amplifier input terminals in both the known arrangement and the arrangement according to the invention.

According to a second aspect of the invention, there is provided a gyrator filter circuit including at its front end a transconductance floating resistor circuit as described above.

The invention will now be described, by way of example only, with reference to the drawings, of which:
Figure 1 is a circuit diagram of a known type of transconductance floating resistor;
Figure 2 is a circuit diagram of a typical transconductance amplifier used in the floating resistor of Figure 1;
Figure 3 is a circuit diagram of a transconductance floating resistor according to a first aspect of the invention;
Figure 4 is a circuit diagram of a modified version of the transconductance floating resistor of Figure 3;
Figure 5 is a circuit diagram of a known gyrator filter fed from a known transconductance floating resistor circuit, and
Figure 6 is a circuit diagram of a known gyrator filter fed from a transconductance floating resistor circuit according to the invention.

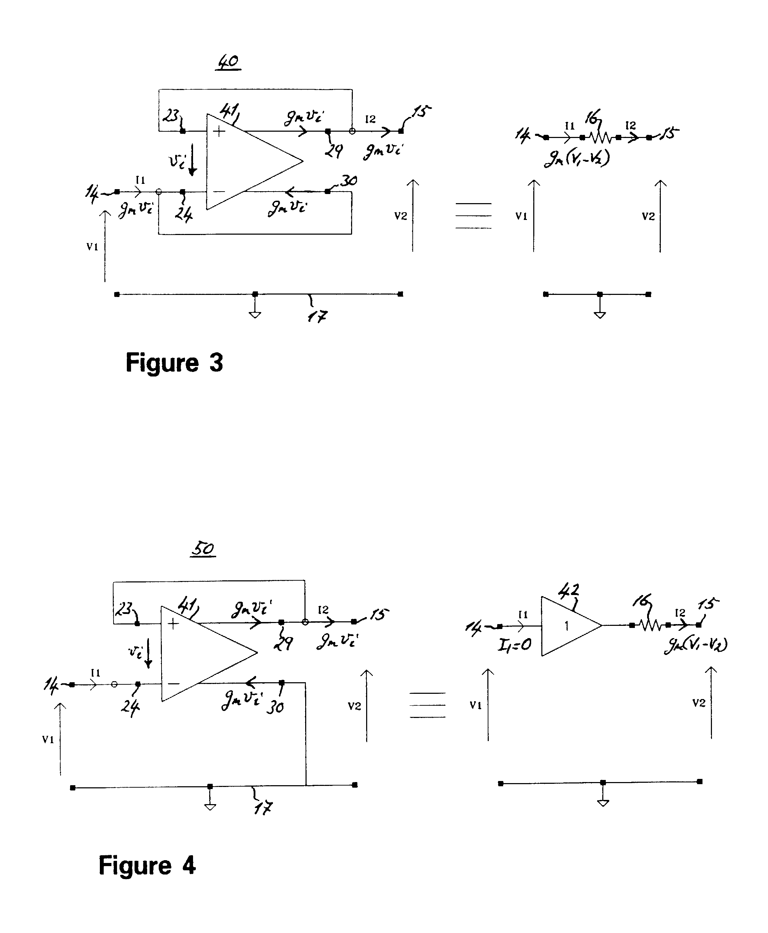

Referring now to Figure 3, there is shown a transconductance floating resistor circuit 40 according to the invention, comprising a transconductance amplifier 41 which takes the form of the differential amplifier illustrated in Figure 2. Corresponding elements in the two diagrams bear the same reference designator.

The output 29 of that half of the differential pair 21, 22 (see Figure 1) marked "+" is fed back to the input 23 of the same half. Similarly, the output 30 of the other half of the differential pair 21, 22 is taken to its corresponding input 24. The arrangement formed in this way is a floating arrangement not directly referenced to a reference potential, and is bidirectional, i.e. either terminal 14, 15 of the circuit may be used as the input. The result is a floating circuit element between the terminals 14 and 15 which is the equivalent of a resistor between those terminals having a value related to the transconductance of the differential amplifier stage. Clearly, the equivalent resistance can be varied by varying that transconductance.

To illustrate how the circuit works, it is first assumed that the base currents of the differential amplifier transistors 31-34 are very small compared with the collector currents which are generated. In other words, the transistors have a high current gain, β. Assuming now the existence of a signal voltage vᵢ between the terminals 23 and 24 of the transconductance amplifier 41, a resulting current will be set up in both outputs 29, 30 of the amplifier equal to gₘvᵢ, where gₘ is the total effective transconductance of the composite differential amplifier 41. (The senses of the currents shown are given by the arrow heads). Since the amplifier is push-pull, the currents on outputs 29 and 30 are of opposite sense and are assumed to be equal through suitable transistor matching. Since now it is assumed that the input currents entering the amplifier 41 on the lines 23, 24 are negligible, the current at the circuit input terminal 14 will be the same as the current flowing through the amplifier output terminal 30 and likewise the current at the circuit output terminal 15 will be the same as that flowing through the amplifier output terminal 29, i.e. gₘvᵢ. The result in equivalent-circuit terms is an input terminal 14 connected to an output terminal 15 via an impedance, the impedance passing a current equal to gₘvᵢ. However, vᵢ=v₁-v₂, hence the impedance must have a value equal to 1/gₘ. Also, because there is no frequency dependence in this impedance term, the impedance must be purely resistive.

The circuit shown in Figure 3 may now be taken and modified to provide the equivalent of a buffer stage followed by a floating resistor, as above, all in one transconductance amplifier 41. This modification is shown as the transconductance stage 50 in Figure 4. In this modified circuit, the arrangement of Figure 3 is maintained, but instead of having the feedback connection between terminals 30 and 24, the output terminal 30 is taken to a reference potential 17. The input of the circuit is constituted by terminal 14, the output by terminal 15.

The operation of this circuit is as follows:

Under the same assumptions as previously, namely that the amplifier input currents on terminals 23 and 24 are negligible and that a voltage vᵢ is present across the amplifier input terminals 23, 24, a current gₘvᵢ is generated on the amplifier output 29 in the sense shown and an equal and opposite current (opposite-facing arrow head) is generated on the other output 30. As before, the current flowing through the circuit output terminal 15 is the same as the current on the output 29, i.e. gₘvᵢ, but this time there is no corresponding current on the circuit input terminal 14 due to the lack of feedback between that point and terminal 30. The current gₘvᵢ on the circuit output terminal 15 will now form a complete circuit through the input circuit of the following filter stage (not shown), back to the amplifier output 30 via the reference level 17. Clearly, because there is (ideally) no signal current demand on the circuit input terminal 14, this input connection is effectively buffered from the output circuit of the amplifier 41, and from any subsequent filter stage as well.

Thus, the circuit of Figure 4 provides the equivalent of an input buffer 42 followed by the floating resistor 16 illustrated in Figure 3. Also, in Figure 4, because the same feedback conditions exist at circuit output terminal 15, i.e. feedback between terminals 29 and 23 of the amplifier 41, as existed in the circuit of Figure 3, the output impedance of the modified stage as seen by a following filter stage is unchanged.

While in the foregoing analysis the input base currents of the transconductance amplifier 41 have been assumed to be zero, in reality, provided the two halves of the amplifier are adequately matched, finite base currents in the two halves will be substantially equal and opposite, still giving rise to equal currents at terminals 14 and 15. However, the value of the floating resistor 16 obtained will differ from the ideal value 1/gₘ by a factor approximately equal to 1 + 1/β.

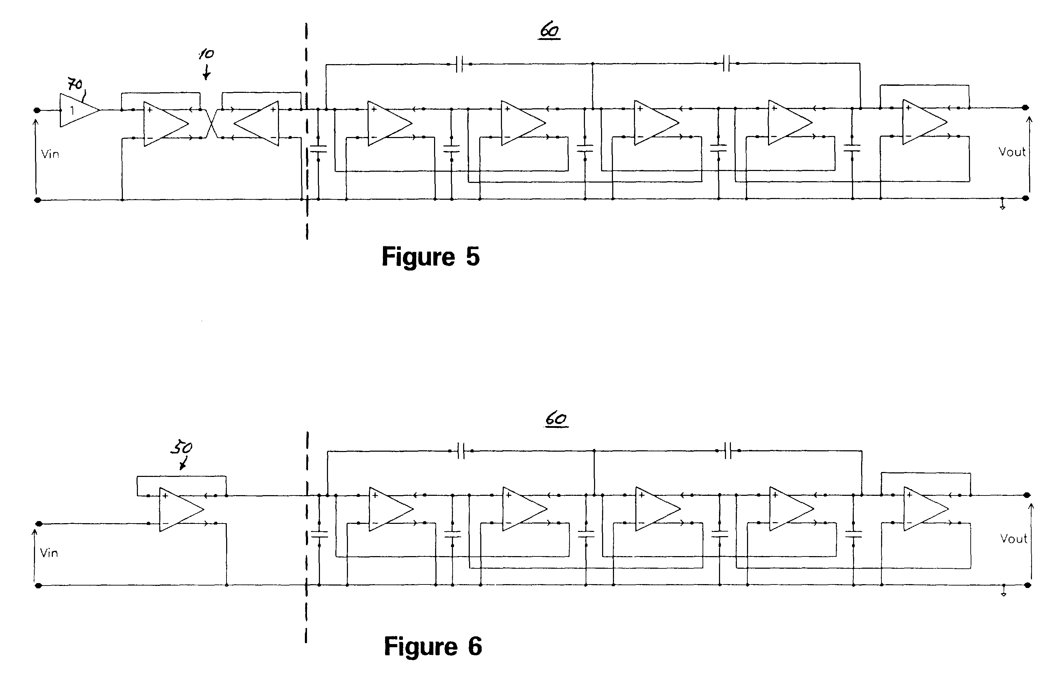

Figures 5 and 6 show both the conventional floating resistor arrangement and the buffer/resistor arrangement according to the invention incorporated into the front end of a typical gyrator filter circuit 60. The conventional resistor circuit 10 in Figure 5 is employed in conjunction with a separate buffer stage 70 in order to achieve the isolation required. The input resistor stage 50 shown in Figure 2 needs no such separate buffer, since, as described above, it performs the function of both buffer and floating resistor simultaneously. Furthermore, it achieves this with a saving in hardware and operating current requirement.

## Claims

1. A transconductance floating resistor circuit comprising a differential transconductance amplifier (41) having first (23) and second (24) inputs and corresponding first (29) and second (30) outputs, the first and second outputs being connected to the first and second inputs, respectively, and the input (14) and output (15) of the floating resistor circuit being taken from the first and second inputs, respectively, of the transconductance amplifier.

2. A transconductance floating resistor circuit as claimed in Claim 1, in which the first output of the transconductance amplifier is connected to a reference potential instead of to the first input of the transconductance amplifier, the reference potential forming a common reference level for the input and output of the floating resistor circuit.

3. A gyrator filter circuit including at its front end a transconductance floating resistor circuit as claimed in Claim 2.

## Patentansprüche

1. Transkonduktanzschaltung mit einem schwebenden Widerstand, enthaltend einen Transkonduktanz-Differenzverstärker (4) mit ersten (23) und zweiten (24) Eingängen und entsprechenden ersten (29) und zweiten (30) Ausgängen, wobei die ersten und zweiten Ausgänge jeweils mit den ersten und zweiten Eingängen verbunden sind und der Eingang (14) und der Ausgang (15) der Schaltung mit dem schwebenden Widerstand jeweils von dem ersten und zweiten Eingang des Transkonduktanzverstärkers abgenommen sind.

2. Transkonduktanzschaltung mit einem schwebenden Widerstand nach Anspruch 1, bei dem der erste Ausgang des Transkonduktanzverstärkers anstelle mit einem ersten Eingang des Transkonduktanzverstärkers mit einem Bezugspotential verbunden ist, das ein allgemeines Bezugspotential für den Eingang und den Ausgang der schwebenden Widerstandsschaltung darstellt.

3. Gyrator-Filterschaltung enthaltend an ihrer Eingangsseite eine Transkonduktanzschaltung mit einem schwebenden Widerstand gemäß Anspruch 2.

## Revendications

1. Circuit résistif à transconductance flottante comprenant un amplificateur différentiel de transconductance (41) possédant une première (23) et une seconde (24) entrée et une première (29) et une seconde (30) sortie correspondantes, la première et la deuxième sortie étant reliées à la première et la seconde entrée, respectivement, l'entrée (14) et la sortie (15) du circuit résistif flottant étant prises à la première et deuxième entrée, respectivement, de l'amplificateur de transconductance.

2. Circuit résistif à transconductance flottante selon la revendication 1, dans lequel la première sortie de l'amplificateur de transconductance est reliée à un potentiel de référence et non à la première entrée de l'amplificateur de transconductance, le potentiel de référence constituant un niveau de référence commun pour l'entrée et la sortie du circuit résistif flottant.

3. Circuit de filtre giratoire comprenant dans sa partie entrée un circuit résistif à transconductance flottante selon la revendication 2.
